(19) Europäisches Patentamt

European Patent Office

Office européen des brevets

(11) Veröffentlichungsnummer: **0 307 641 B1**

(12) **EUROPÄISCHE PATENTSCHRIFT**

(45) Veröffentlichungstag der Patentschrift: **04.11.92**

(21) Anmeldenummer: **88113394.6**

(22) Anmeldetag: **18.08.88**

(51) Int. Cl.⁵: **H03G 3/34**

(54) **Schaltungsanordnung zur Unterdrückung von Störgeräuschen.**

(30) Priorität: **04.09.87 DE 3729656**

(43) Veröffentlichungstag der Anmeldung:
**22.03.89 Patentblatt 89/12**

(45) Bekanntmachung des Hinweises auf die
Patenterteilung:
**04.11.92 Patentblatt 92/45**

(84) Benannte Vertragsstaaten:
**AT BE CH DE ES FR GB GR IT LI LU NL SE**

(56) Entgegenhaltungen:
**EP-A- 0 069 843**
**EP-A- 0 095 774**
**GB-A- 1 417 794**
**GB-A- 2 056 208**

(73) Patentinhaber: **Deutsche Thomson-Brandt
GmbH
Hermann-Schwer-Strasse 3 Postfach 1307
W-7730 Villingen-Schwenningen(DE)**

(72) Erfinder: **Schmitz, Friedrich
Sebastian-Kneipp-Strasse 24
W-7730 Villingen-Schwenningen(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Schaltungsanordnung zur Unterdrükkung von Störgeräuschen, insbesondere von Störgeräuschen beim Ein- und Ausschalten von Audiogeräten.

Bei derartigen Geräten ist es üblich, eine sogenannte Mute-Schaltung einzubauen, die Störgeräusche unterdrückt, welche z.B. als unangenehmes Knacken beim Ein- und Ausschalten hörbar werden. Störgeräusche entstehen z.B. auch beim Umschalten von einem Empfangskanal auf einen anderen, weil durch die mit einer bestimmten Zeitkonstanten sich aufbauende neue Abstimmspannung Sender nacheinander hörbar werden, die dem durchlaufenen Abstimmspannungsbereich entsprechen. Durch die Mute-Schaltung werden auch Störungen unterdrückt, die als Zwischensenderrauschen unangenehme Geräusche verursachen.

Es ist bekannt, zur Unterdrückung derartiger Störgeräusche an den Ausgang des Verstärkers ein Relais oder elektronische Schalter zu legen, die diesen entweder unterbrechen oder kurzschließen. Die Verwendung von Relais bringt technisch eine gute Wirkung, jedoch sind diese sehr kostspielig und im Laufe der Zeit arbeitet die Schaltung wegen der Verschmutzung der Relaiskontakte nicht mehr einwandfrei. Schalttransistoren sind dagegen wesentlich kostengünstiger, besitzen aber auch wiederum gewisse Nachteile. Um eine Absenkung von 80db zu erreichen, sind mindestens zwei über Längswiderstände gegen Massepotential geschaltete Transistoren erforderlich. Diese Längswiderstände besitzen Werte von mindestens 300 Ohm, so daß der Ausgangswiderstand des Verstärkers in nachteiliger Weise auf mindestens 500 Ohm vergrößert wird. Um den Klirrfaktor bei Ausgangsspannungen von bis zu 2 Volt gering zu halten, ist für die Schalttransistoren eine negative Vorspannung von 4 bis 5 Volt notwendig. Ausgangsspannungen, die größer sind, sind dann nicht erreichbar. Eine Mute-Absenkung ist höchstens bis zu einem Wert von 80db erzielbar. Schließlich entstehen während der Umschaltung von Mute-Betrieb auf Wiedergabe-Betrieb starke Verzerrungen.

Es ist bekannt, zwei bipolare elektronische Schalter jeweils in Serie zum Lastwiderstand eines Verstärkers und in dessen gegenkopplungskreis zu legen. Der Verstärker besitzt hier sowohl im Verstärkungs-Betrieb als auch im Mute-Betrieb einen bestimmten Verstärkunsgrad von z.B. 40db. Durch die Nichtlinearität des in Serie zur Lastimpedanz geschalteten elektronischen Schalters und infolge seines endlichen Widerstandes entstehen an diesem nichtlineare Verzerrungen, welche über die Gegenkopplung nicht vollständig beseitigt werden können. Zur Ansteuerung der elektronischen Schalter ist hier eine sehr aufwendige Ansteuerschaltung notwendig, welche nur in integrierter Schaltungstechnik technisch sinnvoll ist, da sie mit zu großem diskretem Aufwand nicht rentabel ist (Europ.Patentanmeldung EP-A-0 095 774).

Der Erfindung liegt die Aufgabe zugrunde, eine Mute-Schaltung zu entwerfen, die sehr kostengünstig ist, die eine wesentlich größere Absenkung erlaubt und die verzerrungsfrei arbeitet. Diese Aufgabe wird durch die im Patenanspruch angegebene Erfindung gelöst. Weitere vorteilhafte Ausgestaltungen der Erfindung ergeben sich aus den Unteransprüchen.

Nachstehend wird die Erfindung mit Hilfe der Zeichnung erläutert.

Figur 1    zeigt ein erstes Ausführungsbeispiel,
Figur 2    zeigt ein zweites Ausführungsbeispiel der Erfindung,
Figur 3    zeigt eine Variante der Figur 1.

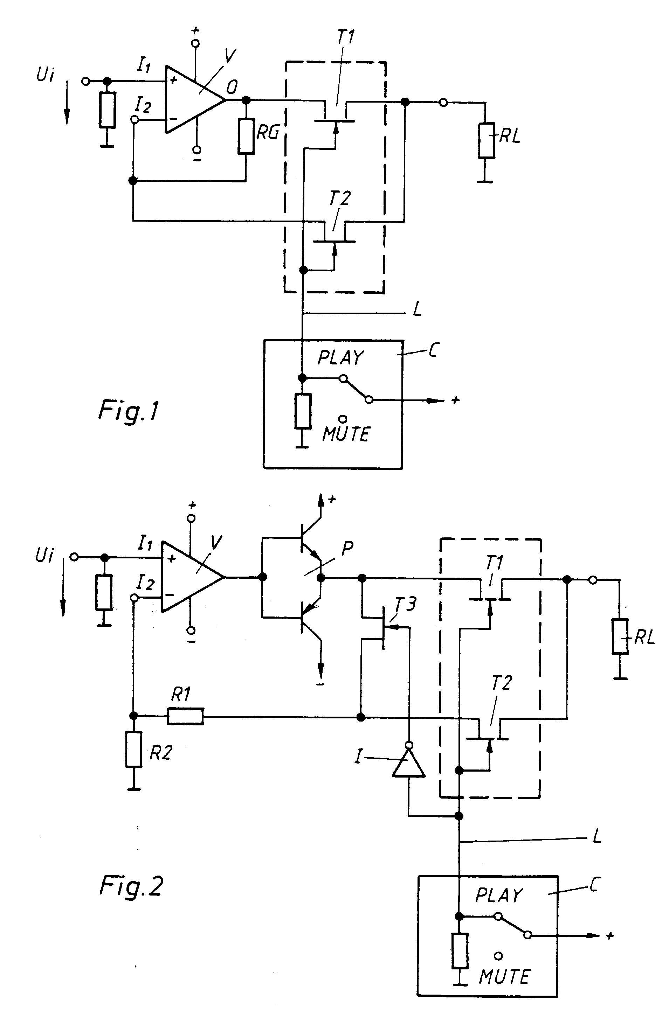

In Figur 1 ist die Erfindung in ihrem prinzipiellen Aufbau dargestellt. Am Eingang I1 eines Verstärkers V liegt die zu verstärkende Eingangsspannung Ui. Der Ausgang O ist über den Gegenkopplungswiderstand RG auf den invertierenden Eingang I2 des Verstärkers V geschaltet. Die Lastimpedanz RL liegt über einen elektronischen Schalter T1 am Ausgang O des Verstärkers V. Der mit der Lastimpedanz RL verbundene Kontakt des Schalters T1 ist über einen weiteren elektronischen Schalter T2 mit dem invertierenden Eingang I2 des Verstärkers V verbunden. Die beiden elektronischen Schalter T1 und T2 können aus diskreten Feldeffekt-Transistoren FET bzw. MOSFET oder auch aus bipolaren Transistoren bestehen, oder sie können in Form eines integrierten Analogschalters zusammengefaßt sein, wie z.B. in der integrierten Schaltung 4066 der Firma MOTOROLA.

Im Verstärker-Betrieb fließt über den Schalter (FET) T1 ein Nutzstrom über die Lastimpedanz RL nach Masse. Dabei entstehen an der Drain-Source-Strecke nichtlineare Verzerrungen. Über den Schalter (FET) T2 liegt der Ausgang des Schalters T1 in der Gegenkopplungsschleife des Verstärkers V. Die durch den FET verursachten Verzerrungen werden durch den als Operationsverstärker arbeitenden Verstärker V kompensiert.

Aufgrund des hohen Eingangswiderstandes des invertierenden Eingangs I2 des Verstärkers V fließt durch den Schalter (FET) T2 praktisch kein Strom, so daß dieser auch keine Klirrleistung liefert. Da die Verzerrungen der Drain-Source-Strecke des Schalters T1 vollkommen kompensiert werden, ist der Ausgangswiderstand als Quellwiderstand für die Lastimpedanz RL praktisch null Ohm.

Im Mute-Betrieb werden durch die Betätigung einer einfach aufgebauten Steuerschaltung C, z.B. in Form eines Umschalters mittels eines geeigneten Potentials auf der Steuerleitung L die Schalter T1 und T2 zugleich gesperrt. Die Gegenkopplungsschleife ist nun über den Widerstand RG und damit der Gleichstromweg vom Ausgang zum invertierenden Eingang geschlossen. Da die Schalter T1 und T2 in diesem Fall sehr hochohmig werden, ergibt sich eine sehr große Dämpfung, welche im mittleren Frequenzbereich den Wert von 100 db erreicht. Die maximale Ausgangsspannung des Verstärkers V ist durch die Betriebsparameter der Feldeffekt-Transistoren gegeben. Durch die selbstsperrende Wirkung der Feldeffekt-Transistoren, d.h. sie werden ohne Betriebsspannung hochohmig, ergeben sich insbesondere beim Einschalten des Verstärkers V Vorteile, da der Ausgang der Schaltung sehr hochohmig von den Einschaltimpulsen einer vorausgehenden Schaltung getrennt ist.

In Figur 2 ist ein zweites Schaltbeispiel dargestellt. Dabei sind für gleiche Bauteile die in der Figur 1 entsprechenden Bezugszeichen verwendet. Hier ist dem Verstärker V eine Leistungsstufe P nachgeschaltet, wobei der Verstätker V hier Z.B. eine Spannungsverstärkung von $v_u = 26db$ besitzt und der nachgeschaltete Leistungsverstärker P eine Verstärkung von 0db. Der Verstärker ist über die Widerstände R1 und R2 gegengekoppelt. Damit im Mute-Betrieb, d.h. wenn der Schalter T2 gesperrt ist, die Gegenkopplungsschleife nicht unterbrochen wird, wodurch der Verstärker in seiner Verstärkung hochlaufen und in die Begrenzung steuern würde, ist ein weiterer Schalter T3 eingebaut, der über den Inverter I von der Steuerschaltung C durchgeschaltet wird. Bei dem Schalter T1 handelt es sich um einen Leistungs-Feldeffekt-Transistor.

Die beschriebenen Schaltungen besitzen gegenüber dem eingangs genannten Stand der Technik den Vorteil, daß kein Vorstrom bzw. keine Vorspannung für den Mute-Betrieb benötigt wird. Das ist z.B. wichtig, wenn die Schaltung in Betrieb gesetzt wird und sich noch keinerlei Versorgungsspannungen aufgebaut haben.
Die Schaltung besitzt nur einen geringen Innenwiderstand, ein Klirrfaktor ist praktisch nicht vorhanden. Die Schaltung besitzt eine hohe Spannungsfestigkeit. Störgeräusche werden beim Wirksamwerden der Mute-Schaltung vollkommen eliminiert.

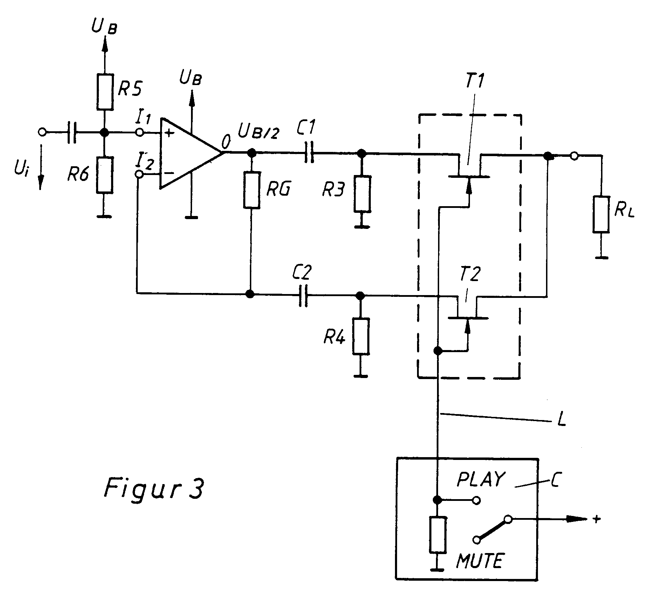

In Figur 3 ist eine weitere Variante der Schaltungsanordnung nach Figur 1 dargestellt, indem an den Ausgang des Verstärkers V sowie in den Gegenkopplungszweig je ein Kondensator C1 bzw. C2 mit Entladewiderständen R3 bzw. R4 geschaltet sind. Dadurch ist es möglich, den Verstärker V nur mit einer gegen Masse bezogenen Spannung zu betreiben. An den Eingang I1 ist ein aus zwei gleichgroßen Widerständen R5 und R6 bestehender Spannungsteiler geschaltet.

**Patentansprüche**

1. Schaltungsanordnung zur Unterdrückung von Störgeräuschen beim Ein- und Ausschalten von Audiogeräten, wobei an den Ausgang eines Verstärkers in Serie zu seiner Lastimpedanz sowie in seinem Gegenkopplungskreis je ein elektronischer Schalter angeordnet ist, dadurch gekennzeichnet, daß der im Gegenkopplungskreis angeordnete elektronische Schalter (T2) zwischen den mit der Lastimpedanz (RL) verbundenen Kontakt des in Serie mit der Lastimpedanz (RL) liegenden elektronischen Schalters (T1) und den invertierenden Eingang (I2) des Verstärkers (V) geschaltet ist.

2. Schaltungsanordnung nach Anspruch 1, dadurch gekennzeichnet, daß die elektronischen Schalter (T1,T2) über eine gemeinsame Steuerleitung (L) zugleich ein- und ausschaltbar sind.

3. Schaltungsanordnung nach Anspruch 1 oder 2, dadurch gekennzeichnet, daß der elektronische Schalter (T2) über den im Gegenkopplungskreis liegenden Gegenkopplungswiderstand (RG) dem elektronischen Schalter (T1) parallelgeschaltet ist.

4. Schaltungsanordnung nach Anspruch 1, dadurch gekennzeichnet, daß ein weiterer elektronischer Schalter (T3) vorgesehen ist, der im Mute-Betrieb die Gegenkopplungsschleife vom Ausgang einer Leistungsverstärkerstufe (P) zum invertierenden Eingang (I) einer vorgeschalteten Spannungsverstärkerstufe ($V_u$) schließt.

5. Schaltungsanordnung nach Anspruch 1, 2 oder 3, dadurch gekennzeichnet, daß der Verstärker (V) im Betrieb den Verstärkungsgrad $v_u = 0db$ besitzt.

**Claims**

1. Switching arrangement for the suppression of noise disturbances when switching audio apparatus on and off, wherein a respective electronic switch is arranged at the output of an amplifier in series with its load impedances as well as in its negative feedback circuit, characterised in that, the electronic switch (T2) arranged in the negative feedback circuit is connected between the contact connected to the load impedance (RL) of the electronic switch (T1) located in series with the load impedance (RL), and the inverting input (I2) of the amplifier (V).

2. Switching arrangement in accordance with Claim 1, characterised in that, the electronic switches (T1, T2) can be turned -on and -off at the same time via a common control lead (L).

3. Switching arrangement in accordance with Claim 1 or 2, characterized in that, the electronic switch (T2) is connected in parallel with the electronic switch (T1) via the negative feedback resistor (RG) located in the negative feedback circuit.

4. Switching arrangement in accordance with Claim 1, characterised in that, a further electronic switch (T3) is provided which in the muting mode closes the negative feedback loop from the output of a power amplifier stage (P) to the inverting input (I) of a preceding voltage amplifier stage (Vu).

5. Switching arrangement in accordance with Claim 1,2 or 3, characterised in that, in operation, the amplifier (V) has an amplification level vu = 0 db.

**Revendications**

1. Dispositif de circuit pour supprimer les parasites lors de la mise en marche et de l'arrêt d'appareils son, un commutateur électronique étant placé respectivement à la sortie d'un amplificateur en série avec son impédance de charge ainsi que dans son branchement de contre-réaction, **caractérisé en ce que** le commutateur électronique (T2) placé dans le branchement de contre-réaction est commuté entre le contact, qui est relié à l'impédance de charge (RL), du commutateur électronique (T1) qui est en série avec l'impédance de charge (RL) et l'entrée d'inversion (I2) de l'amplificateur (V).

2. Dispositif de circuit selon la revendication 1, **caractérisé en ce que** les commutateurs électroniques (T1, T2) peuvent être mis en marche et arrêtés en même temps par une ligne pilote (L) commune.

3. Dispositif de circuit selon la revendication 1 ou 2, **caractérisé en ce que** le commutateur électronique (T2) est monté en parallèle avec le commutateur électronique (T1) par la résistance de contre-réaction (RG) qui se situe dans le branchement de contre-réaction.

4. Dispositif de circuit selon la revendication 1, **caractérisé en ce qu'**il est prévu un autre commutateur électronique (T3) qui. en mode silencieux, ferme la boucle de contre-réaction de la sortie de l'étage d'amplification de puissance (P) vers l'entrée d'inversion (I) d'un étage d'amplification de tension placé en amont (Vu).

5. Dispositif de circuit selon la revendication 1, 2 ou 3, **caractérisé en ce que** l'amplificateur (V) en fonctionnement possède le coefficient d'amplification $V_u$ = 0 dB.

Fig.1

Fig.2

Figur 3